# EUROPEAN PATENT APPLICATION

(11) **EP 4 027 209 A1**
(43) Date of publication of application: **13.07.2022**
(21) Application number: 22150800.5
(22) Date of filing: 10.01.2022
(51) Int. Cl.: G05B 19/418

(54) **SYSTEM AND METHOD FOR AUGMENTED REALITY (AR) ASSISTED MANUFACTURE OF COMPOSITE STRUCTURES AND BONDED ASSEMBLIES**

(30) Priority: 08.01.2021 US 202117144893
(71) Applicant: B/E Aerospace, Inc., Winston-Salem, NC 27105 (US)
(72) Inventor: TATE, Stephen H., Downpatrick (GB); McKIBBIN, Nigel, Katesbridge (GB)
(74) Representative: Dehns

(57) **Abstract**

A method for augmented reality (AR) assisted ply placement for assembly and manufacture of composite structures is disclosed. In embodiments, the method includes providing AR viewing devices (402) to individuals directly involved in the assembly of the composite structure and loading an assembly sequence for the particular composite structure. For each step of the assembly structure, the AR viewing devices display virtual representations of each ply or layer in the order of assembly, indicating the proper positioning and orientation of each ply over adjacent previously installed layers or plies. The AR viewing devices display any operator alerts associated with assembly steps and accept control input from the operators indicating completion of an assembly step. The AR devices capture or record the completion of each step and generate a record of the full assembly sequence based on each completed step for quality assurance.

## Description

### BACKGROUND

Composite structures and components (e.g., composite laminates) may comprise multiple layers of fibrous material, each layer in turn including multiple sub-layers or plies installed above the preceding plies or sub-layers atop one or more molds or core materials (e.g., honeycomb cores, pre-preg materials) to form a lightweight yet durable structure. Such composite structures may include aircraft and vehicular interior panels (e.g., seating panels, footrests, doors, aprons, and other interior surfaces) but may also include exterior control surfaces depending upon the selection of materials. As such structural components may involve complex geometries and variances in thickness and/or reinforcement, great care must be taken to ensure accuracy and precision in ply placement. Conventional approaches have evolved from painstaking manual measurement and/or cumbersome manufacturing templates to the use of laser projection. However, laser systems remain expensive and may not be optimally suited for complex geometries or layouts (e.g., scanning multiple molds). Nor are laser projection systems equipped to display ply seating positions or orientations, splice/dart locations, or dress/drape methods for structural components incorporating fabric layers or coverings. Further, if multiple operators are using a laser projection system, the overall pace of assembly will be determined by the slowest operator or task.

Similarly, some composite structures may incorporate bonded assemblies (e.g., thermoforming, co-curing, co-bonding of components), hook-and-loop fasteners, clips, and other like elements by which secondary components may be added to primary components. Currently, incorporating bonded assemblies and fasteners into component assembly requires prototype fixtures which incorporate both a lengthy design and manufacturing process (4 weeks on average) and are vulnerable to subsequent design changes based on assembly revisions. Further, even with extended life cycles these fixtures may be subjected to normal wear and tear as well as adhesive buildup; in addition, they require extensive storage space.

### SUMMARY

A method for augmented reality (AR) assisted manufactured assembly of composite components is disclosed. In embodiments, the method includes providing an augmented reality (AR; e.g., virtual reality (VR), mixed reality (MR)) viewing device to operators (e.g., participants, observers) involved in a composite structure assembly. The method includes identifying, via the AR viewing devices, the composite structure to be assembled or manufactured, each composite structure having an associated dataset including all sequences of ordered assembly steps for assembling that composite structure. The method includes loading the associated dataset for display and operator interaction via the AR viewing device. For each assembly step of each assembly sequence, the method includes: displaying AR objects via the viewing device, each AR object indicating a placement or orientation of a layer, ply, fastener, or other component to be added relative to any previously assembled components (e.g., based on the current step or sequence and any prior sequences or steps already executed); displaying any operator alerts associated with the current assembly step; accepting control input from the operator via the AR viewing device; and generating a recording verifying the completion of the assembly step. The method includes producing, based on the set of verified assembly steps, a recording verifying the completion of all associated or necessary assembly sequences.

In some embodiments, the composite structure includes a set of composite layers (e.g., a single assembly step may incorporate multiple layers) assembled in sequence over a mold. The method includes displaying, via the AR viewing device, AR objects indicating the placement or orientation of a particular layer or layers.

In some embodiments, each layer may incorporate one or more composite plies, and the method include displaying, via the AR viewing device, AR objects indicating the placement or orientation of a particular ply or plies.

In some embodiments, the method includes displaying, via the AR viewing device, assembly locations associated with the current assembly step, e.g., a splice or dart location.

In some embodiments, the method includes displaying, via the AR viewing device, dress and drape methods associated with the current assembly step.

In some embodiments, the method includes displaying, via the AR viewing device, additional dataset information relevant to the current composite structure, e.g., bills of materials, instructional video clips, and technical drawings and illustrations.

In some embodiments, the method includes identifying, via the AR viewing device, a bonded assembly incorporating multiple sets of fastener components (e.g., hook and loop fasteners, clips) attached to a backing layer. The method includes displaying, via the AR viewing device, AR objects indicative of a placement or orientation of a component or set of components (e.g., fasteners of a certain type added via the current assembly step).

In some embodiments, the method includes identifying the particular composite structure (e.g., or type thereof) via the AR viewing device by scanning the field of view for image targets indicative of the composite structure. For example, image targets may include QR codes or other encoded information attached to a mold or backing layer, a component or part of the composite structure, or a work order for the composite structure. In some embodiments, the method includes identifying the composite structure by scanning or identifying the mold, backing layer, component or part, or work order itself.

In some embodiments, the method includes displaying, via the AR viewing device, instructions for the operator.

In some embodiments, the method includes displaying, via the AR viewing device, operator alerts associated with a curing oven (e.g., for curing layers or plies for subsequent assembly or attachment).

In some embodiments, the method includes displaying, via the AR viewing device, operator alerts associated with a ply cutter (e.g., for cutting of layers or plies for subsequent assembly or attachment).

In some embodiments, the method includes: accepting, via the AR viewing device, control input in the form of spoken instructions from the operator; and determining a current assembly step or sequence based on the spoken instructions.

In some embodiments, the method includes displaying, via the AR viewing device, an interactive menu and accepting control input from the operator via the interactive menu.

In some embodiments, the method includes initiating, via the AR viewing device, the next assembly step of a current assembly sequence based on the received control input, e.g., upon completion of a current or prior assembly step.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is an illustration of a structural composite panel and its component structures;
FIGS. 2A and 2B are detailed illustrations of the component structures of the structural composite panel of FIG. 1;
FIG. 3 is a tabular illustration of an assembly sequence for the structural composite panel of FIG. 1 according to example embodiments of this disclosure;
FIG. 4 is a block diagram of an augmented reality (AR) assisted system for assembly and manufacture of structural composites;
FIGS. 5A through 5D are illustrations of AR displays presented by the AR-assisted system of FIG. 4 for assembly of the structural composite panel of FIG. 1;
FIGS. 6A and 6B are illustrations of a bonded assembly and the AR-assisted system of FIG. 4;
FIG. 6C is an illustration of an AR display of the bonded assembly of FIGS. 6A and 6B presented by the AR-assisted system of FIG. 4;
and FIG. 7 is a process flow diagram for an AR-assisted method of assembling structural composites according to example embodiments of this disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to the use of augmented reality (AR; e.g., virtual reality (VR), mixed reality (MR)) to facilitate component placement during the assembly and bonding of composite structures. Wearable AR devices provide assemblers with holographic overlays of each successive layer of plies or components detailed to indicate and ensure proper alignment, placement, and bonding of each component. Assemblers may interact via the AR devices with the holographic overlays as well as monitor the cutting and curing of plies and components. Further, the AR devices provide quality verification, remote support, and standardized training by capturing each step of the assembly and bonding processes.

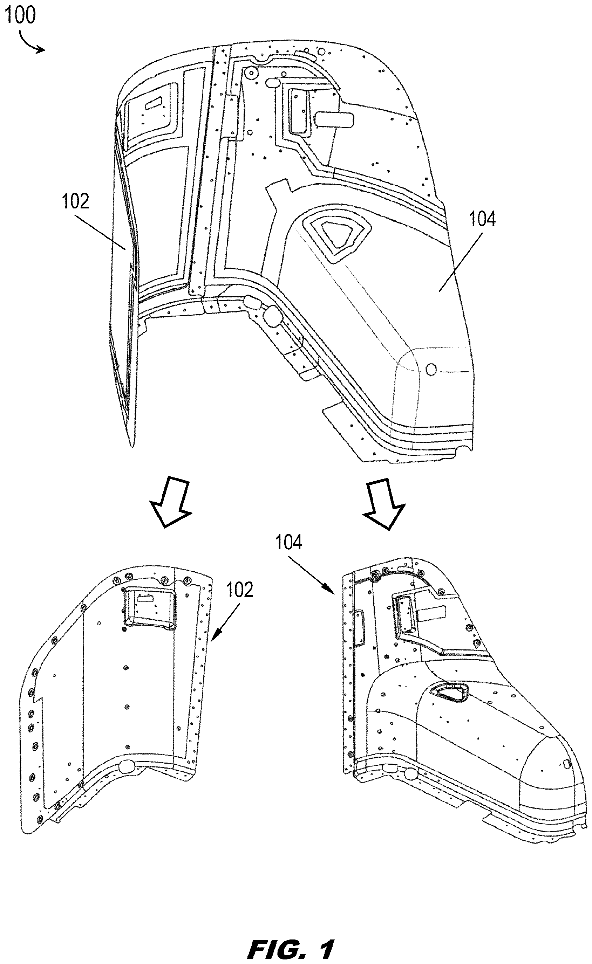

### FIGS. 1 through 3-COMPONENT DETAIL

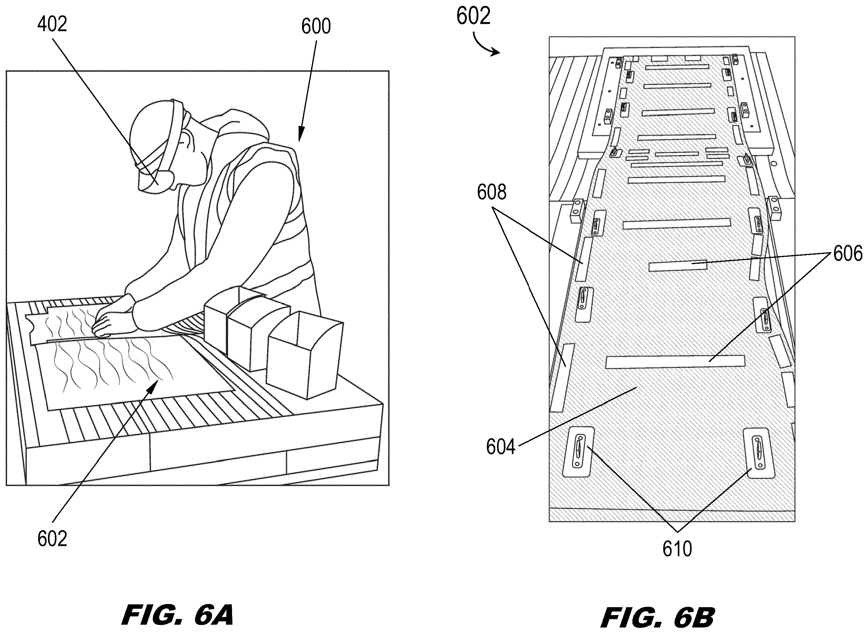

Referring to FIG. 1, a structural composite panel 100 is disclosed. The structural composite panel 100 may be an aircraft seating panel consisting of two separate composite structures, e.g., an aisle panel 102 and a footwell panel 104. The aisle panel and the footwell panel 104 may each be separately assembled and then bonded together into the structural composite panel 100. The inventive concepts disclosed herein are not limited to aircraft or to any particular type or subclass thereof, but may be applied to aircraft interior or exterior panels as well as structural composites and bonded assemblies (disclosed in greater detail below; see, e.g., FIGS. 6A through 6C) for ground-based or water-based vehicles.

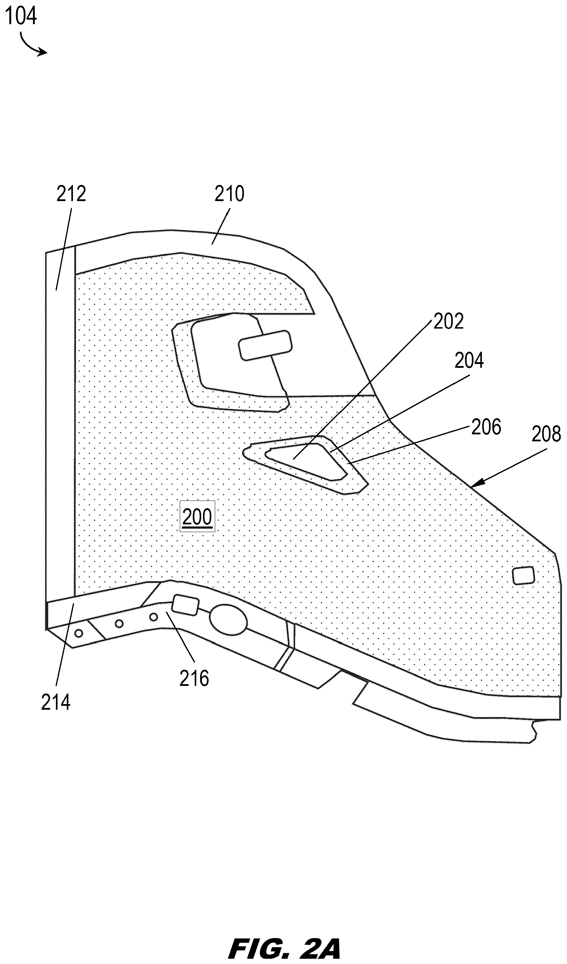

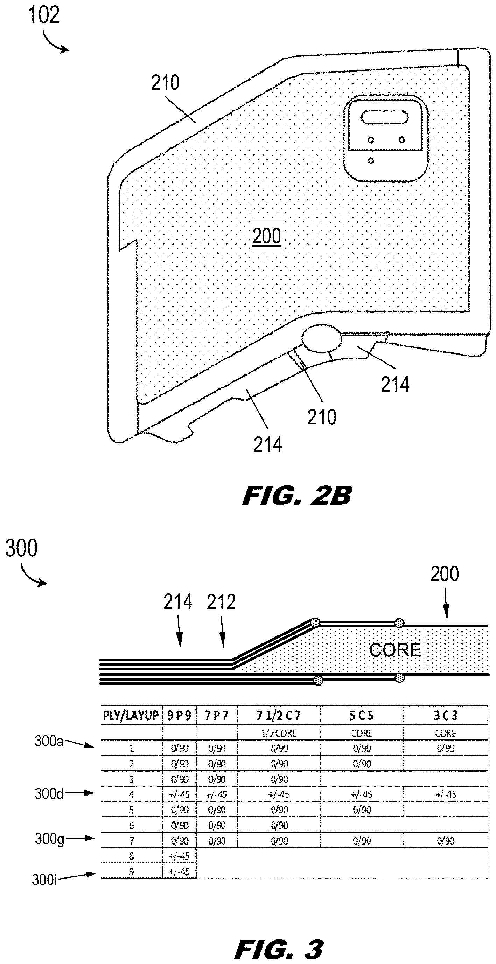

Referring also to FIGS. 2A and 2B, both the aisle panel 102 and the footwell panel 104 may comprise central core sandwich areas 200 with areas of additional and variable reinforcement throughout. For example, the central core sandwich areas 200 of both the aisle panel 102 and footwell panel 104 may comprise a core material (e.g., thermoplastic honeycomb core) sandwiched between two or three plies on either side, e.g., "2-core-2", or "2C2"/"3-core-3" or "3C3". Further, the aisle panel 102 and footwell panel 104 may at some points not incorporate core materials and instead consist solely of layers of plies (or, e.g., may incorporate angled or tapering half-core layers of core material transitioning from a full core at one end to no core at the opposite end. For example, the central area 200 of the footwell panel 104 may be "3 plus 3" or "3 P 3" (202) transitioning into "3 1/2 C 3" (204) followed by a crown of "4 C 3" (206), all set into the 3C3 central core sandwich area 200. Likewise, the edges of the aisle panel 102 and footwell panel 104 may incorporate trimmed edges 208 (e.g., nonstandard edges of the central core sandwich areas 200 where no additional reinforcements are added and the nonstandard edge is trimmed to adapt to an aircraft interior profile (e.g., a bulkhead or other interior panel)) in the central core sandwich area 200, or may add reinforcing plies such that portions of the aisle panel and footwell panel may be 5 P 5 (210), 7 P 7 (212), 9 P 9 (214) or even 11 P 11 (216).

### FIG. 3-ASSEMBLY SEQUENCE AND STEPS

Due to the variable structure of the aisle panel 102 and footwell panel 104, the ply assembly process (e.g., lay-up process) may be staggered. For example, referring also to FIG. 3, the aisle panel 102 may be assembled according to an assembly sequence 300 comprising nine assembly steps 300a-300i (e.g., note that portions of the outer edges of the aisle panel are 9 P 9 (214)). For example, at each assembly step 300a-300i of the assembly sequence 300 plies may be added at the 9 P 9 edges 214, but the addition of plies to the 3 C 3 core sandwich area 200 may be staggered to the first, fourth, and seventh steps 300a, 300d, 300g.

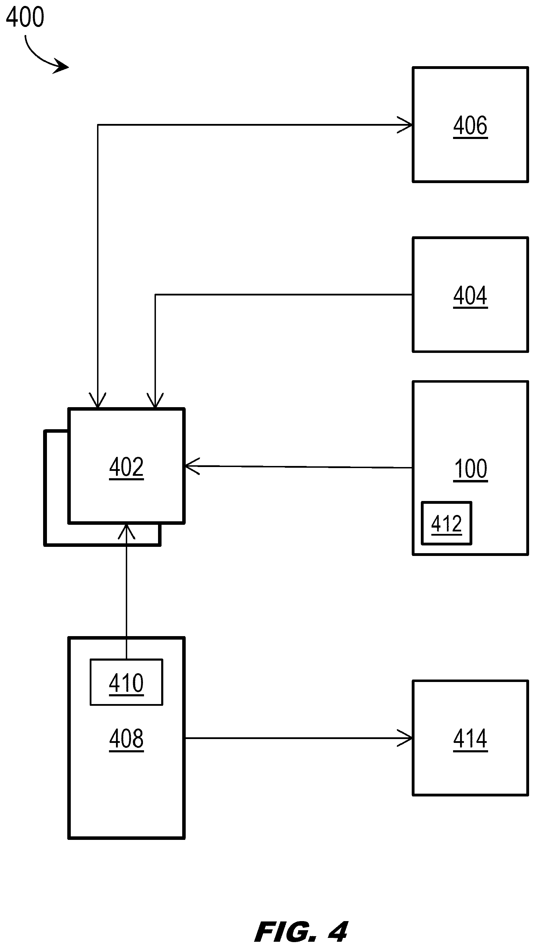

### FIG. 4-AR ASSISTED ASSEMBLY SYSTEM

Referring now to FIG. 4, an augmented reality (AR) assisted system 400 for assembly of a structural composite panel 100 is disclosed. The system 400 may include one or more AR viewing devices 402, curing oven 404, and ply cutter 406.

In embodiments, the AR viewing devices 402 may incorporate onboard control processors and data storage (e.g., memory) and/or may be wirelessly linked to a central processing unit 408 incorporating control processors and data storage configured for generating and/or storing assembly sequences 410 for the structural composite panel 100. For example, each assembly sequence 410 may include three-dimensional AR/holographic ply representations of each ply or layer component of the structural composite panel 100 and any associated sequences of assembly steps for optimal assembly of the structural composite panel.

In embodiments, the assembly process may commence with the loading of the appropriate assembly sequence 410 for display and interaction via the AR viewing devices 402. For example, the operator may scan the structural composite panel 100 for image targets identifying a specific structural composite or component and loading its associated assembly sequences 410. The image targets may include, but are not limited to, QR codes or other encoded information (412) attached to, or incorporated into, a component of the structural composite panel 100 or a work order for the structural composite panel. If, for example, the structural composite panel 100 is to be assembled via the sequential lay-up of individual plies or layers over a mold or backing layer, the encoded information may be attached to or incorporated into the mold or backing layer. In some embodiments, a structural composite panel 100 may be identified via visual recognition of the mold, backing layer, component, or part via the AR viewing devices 402 (e.g., the mold, backing layer, component, or part, may itself serve as a data point identifiable by the AR viewing devices).

In embodiments, each ply representation may graphically incorporate any associated splice or dart locations, dress or drape methods, fastener elements, and alignment indicators associated with assembling or bonding the corresponding ply or layer to any adjacent plies or layers. In some embodiments, assembly sequences 410 may additionally incorporate detailed illustrations of each ply and its associated indicators as well as any bills of materials or specifications associated with the corresponding ply materials.

In embodiments the AR viewing devices 402 may be worn by operators directly involved in the assembly of the structural composite panel 100 or other individuals, e.g., quality control personnel, supervisors, or other observers viewing the assembly process for training purposes. For example, the operator or operators may load any necessary assembly sequences 410 to the AR viewing devices 402 and/or central processing unit 408 prior to the assembly process or at its outset. The AR viewing devices 402 may guide the operators through each step or layer of the assembly process by displaying, at each assembly step, holographic ply representations superimposed over the actual plies to be attached or added at that assembly step, positioned and oriented to indicate the proper alignment of the ply and any additional assembly details (e.g., splice/dart locations, dress/drape methods, fastener elements). In some embodiments, AR viewing devices 402 may include both wearable viewers worn by individuals directly involved in the assembly process as well as tablets or other portable computing and display devices used by observers or trainees.

In embodiments, the assembling operators may indicate completion of an assembly step, or view other portions of the assembly sequences 410, via control input submitted via the AR viewing devices 402. For example, the AR viewing devices 402 may display interactive menus within the field of view of the operators, allowing the operators to select (e.g., via gesture-based interaction with the menu) a particular layer or ply to be displayed, to select additional details (e.g., bills of materials, specification drawings, technical illustrations) associated with a displayed layer or ply, or to indicate completion of a layer, ply, or assembly step and advance to the subsequent layer, ply, or assembly step. In some embodiments, the AR viewing devices 402 may include microphones configured to capture spoken instructions from operators. For example, the AR viewing devices 402 may advance to the next assembly step, or manipulate or select AR objects to be displayed within the field of view of the AR viewing devices, based on the spoken instructions received. Spoken instructions may include, for example, preprogrammed sequences executable when particular words or phrases (e.g., "next", "next step") are heard and recognized by the AR viewing devices 402.

In embodiments, other individuals not directly involved in the assembly process may likewise be able to follow and observe via AR viewing devices 402 of their own. In addition, an AR recording 414 may be generated of the assembly process, showing each assembly step as it appears to the operators and including any audio commentary provided by the operators and/or observers. For example, AR recordings 414 of the assembly process may be used to verify assembly procedures for quality assurance purposes, or to provide standardized training to assembly personnel anywhere in the world.

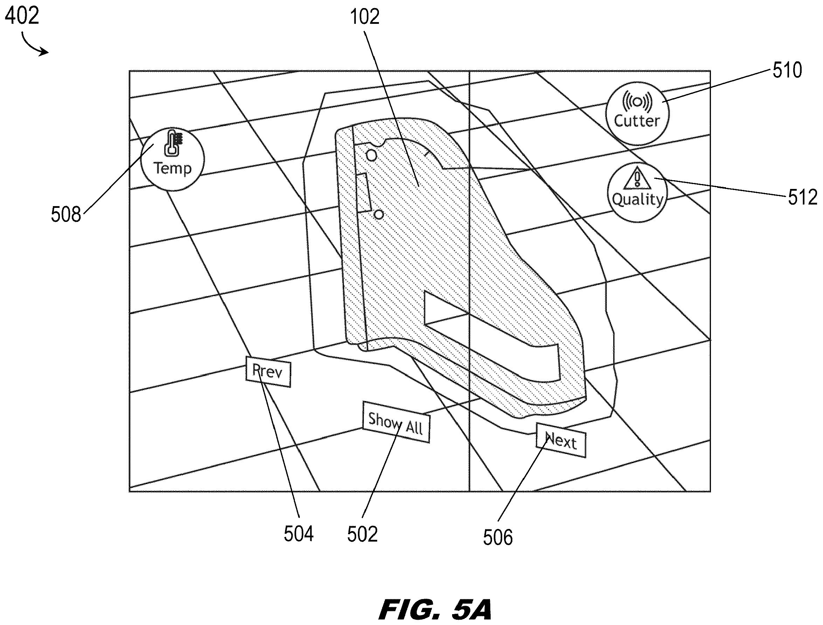

### FIGS. 5A through 5D-AR VIEWS AND CONTROLS

Referring also to FIGS. 5A through 5C, fields of view (e.g., heads-up display) of the AR display devices 402 are disclosed.

In embodiments, referring in particular to FIG. 5A, the AR display device 402 may be configured for display of a main menu corresponding to an overview of the footwell panel 102 currently under assembly. For example, the main menu may include click-throughs 502 to the full assembly sequence (410, FIG. 4), or to prior/subsequent steps (504, 506) in the assembly sequence. The AR display device 402 may allow the operators to monitor the temperature (508) of the curing oven (404, FIG. 4) or control (510) the ply cutter 406, monitoring or controlling the curing or cutting of plies or bonded assemblies associated with a particular assembly step (e.g., a subsequent or future assembly step) while the plies or bonded assemblies associated with a prior or current assembly step are being attached or installed. In embodiments, the AR viewing devices 402 may display quality alerts (512) to the operators as needed.

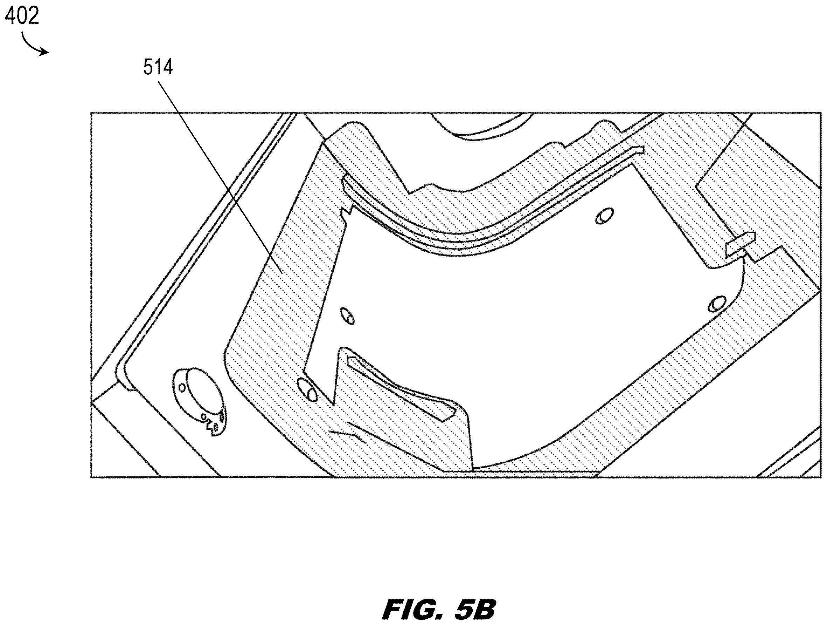

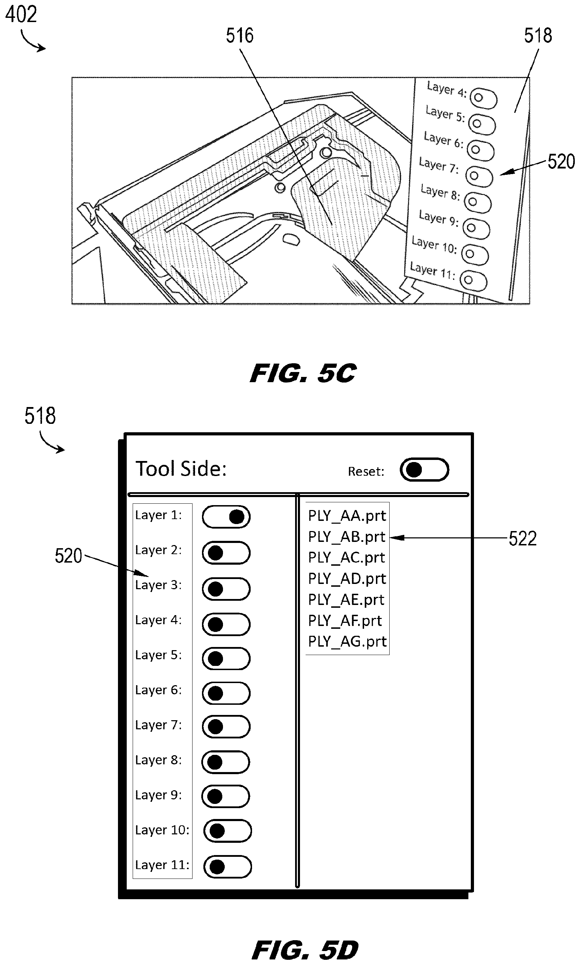

Referring also to FIGS. 5B through 5D, in embodiments the AR display devices 402 may display ply representations 514, 516 according to the currently active assembly step or as selected by the operators. For example, referring in particular to FIGS. 5C and 5D, an interactive menu 518 may be displayed indicating, e.g., every layer (520) of the structural composite panel 100 under assembly and any active ply representations (522) associated with currently selected layers. The operator may, via the interactive menu 518, select one or more active layers 520; when one or more layers are selected, a list of the active ply representations 522 associated with the active layers may be presented via which the operators may select a specific ply representation or representations to be displayed.

### FIGS. 6A through 6C—BONDING ASSEMBLIES

Referring now to FIGS. 6A through 6C, in embodiments the AR viewing devices 402 may similarly present assembly sequences (410, FIG. 4) and individual elements thereof to assemblers (600) of bonded assemblies 602, e.g., structural composite panels (100, FIG. 1) and/or fabric panels attachable to the structural composite panels. For example, bonded assemblies 602 may incorporate a backing layer 604 (e.g., thermoformed plastic or like flexible fabric) to which fasteners and/or other components (e.g., including other thermoformed components or parts) may be bonded or attached according to the assembly sequences 410.

In embodiments, the use of AR viewing devices 402 may eliminate the need to design and manufacture (and occasionally redesign and remanufacture in response to design revisions), store, and replace prototype fixtures for fastener elements. For example, while bonded assemblies 602 may require a less precise assembly process than structural composite panels 100, prototype fixtures for these bonded assemblies (as noted above) may be subject to adhesive buildup and/or wear and tear which may shorten their lifecycle. For example, referring in particular to FIG. 6B, the bonded assembly 602 may incorporate two distinct types (interior fasteners 606, edge fasteners 608) of hook and loop fasteners and clips 610.

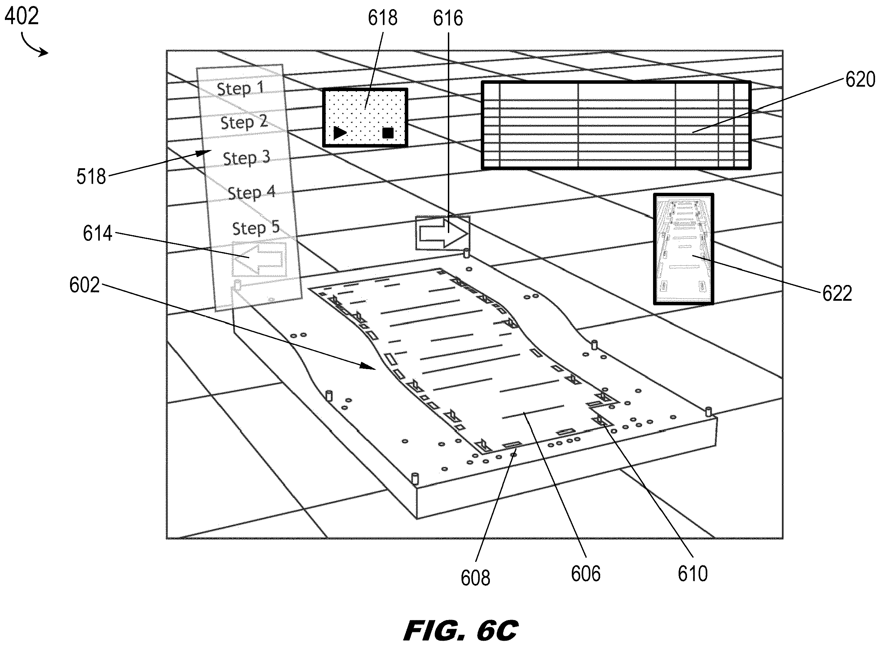

In embodiments, referring also to FIG. 6C, the AR viewing devices 402 may load and display an assembly sequence (410, FIG. 4) incorporating a sequence of assembly steps 612 for adding all necessary fastener elements to the bonded assembly 602 in a predetermined order, e.g., interior fasteners 606 first, then edge fasteners 608, and finally clips 610. The AR viewing devices 402 may additionally display interactive menus 518; markers 614, 616 allowing the operator to respectively advance to the next assembly step or return to the previous assembly step; instructive video clips 618 describing best practices or addressing frequently asked questions; bills of materials 620; and/or technical illustrations 622.

In embodiments, the AR viewing devices 402 similarly receive operator input (e.g., via interactive menus 518 or via spoken instructions by the operator) to verify the completion of assembly steps and of the assembly sequence (410, FIG. 4). The display presented by the AR viewing devices 402 (e.g., the completion of each assembly step of the assembly sequence 410, and any explanatory commentary offered by the operator) may similarly be captured or recorded for quality assurance, remote support, or standardized training purposes (e.g., allowing consistent training procedures to ensure consistently high quality assemblies anywhere in the world manufacturing is occurring).

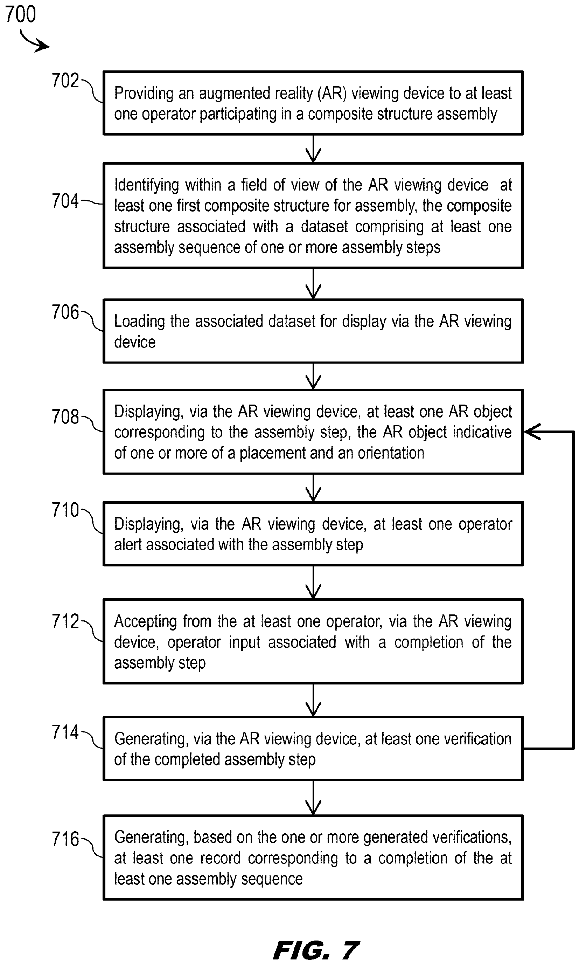

### FIG. 7-METHOD

Referring now to FIG. 7, the method 700 may be implemented by the AR-assisted system 400 and may include the following steps.

At a step 702, AR viewing devices are provided to operators participating in the assembly of a composite structure (e.g., composite panel, combination of one or more such composite panels, bonded assembly). In some embodiments, AR viewing devices may include wearable AR viewing devices as well as tablets or other portable devices configured to present an AR display, and may additionally be provided to observers, trainees, or other individuals not directly participating in the assembly process.

At a step 704, the AR viewing device identifies within its field of view the composite structure to be assembled. For example, the composite structure may be an structure panel comprising multiple layers or plies assembled in sequence over a mold. In some embodiments, the composite structure may be a bonded assembly incorporating multiple sets of fastener elements and components bonded to a backing layer. In some embodiments, the AR viewing device identifies the composite structure by scanning encoded information (e.g., a QR code) attached to a component, backing layer, mold, or work order; in some embodiments the composite structure may be identified by scanning the component, backing layer, mold, or work order itself.

At a step 706, the AR viewing device loads the dataset associated with the identified composite structure for display and interaction. For example, each dataset includes any associated sequences of assembly steps for assembling or manufacturing the identified composite structure.

Steps 708-714 may apply to each assembly step of the assembly sequence. At the step 708, for each assembly step of the assembly sequence, the AR viewing device displays AR objects corresponding to the current assembly step, e.g., indicating the proper placement and orientation of any layer or ply over any previously applied layers or plies. In some embodiments, the displayed AR objects may include any appropriate splice and dart locations. In some embodiments, the displayed AR objects may include any appropriate dress and drape methods. In some embodiments, the displayed AR objects may include bills of materials, video clips, or technical drawings and illustrations. In some embodiments (e.g., when the composite structure is a bonded assembly), the displayed AR objects may include hook and loop fastener placements, clip placements, and other placement or orientation indicators for bonded assembly components.

At a step 710, the AR viewing device displays operator alerts associated with a particular assembly step. In some embodiments, the displayed operator alerts include instructions to the operator. In some embodiments, the displayed operator alerts include an interactive menu capable of displaying and/or traversing the full assembly sequence. In some embodiments, the displayed operator alerts include monitoring information or control sequences for a curing oven (e.g., monitoring oven temperature). In some embodiments, the displayed operator alerts are associated with a ply cutter (e.g., monitoring the cutting of subsequent or future plies).

At a step 712, the AR viewing device accepts operator input indicating a completion of an assembly step. In some embodiments, operator input may be submitted via the displayed interactive menu or as spoken instructions captured by a microphone of the AR viewing device. For example, operator input may be able to cause the AR viewing device to display other steps of the assembly sequence or additional information relevant to the current assembly step, e.g., technical illustrations, instructive video clips, bills of materials. In some embodiments, operator input indicative of the completion of an assembly step may signal the AR viewing device to initiate the next or subsequent assembly step in the assembly sequence.

At the step 714, the AR viewing device generates a verification of each completed assembly step. For example, the AR viewing device may record or capture the operator input indicating the completion of each assembly step.

At a step 716, the AR viewing devices generate a record documenting or capturing the completion of the full assembly sequence based on the captured verifications of each completed assembly step. For example, the AR viewing device may record the interactive display presented to the operators and any explanatory audio commentary offered by the operators, e.g., for quality assurance or standardized training in best practices.

### CONCLUSION

It is to be understood that embodiments of the methods disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

Although inventive concepts have been described with reference to the embodiments illustrated in the attached drawing figures, substitutions may be made herein without departing from the scope of the claims. Components illustrated and described herein are merely examples of a system/device and components that may be used to implement embodiments of the inventive concepts and may be replaced with other devices and components without departing from the scope of the claims. Furthermore, any dimensions, degrees, and/or numerical ranges provided herein are to be understood as non-limiting examples unless otherwise specified in the claims.

## Claims

1. A method for augmented reality, AR, assisted manufactured assembly of composite components, the method comprising:
providing an augmented reality, AR, viewing device (402) to at least one operator participating in a composite structure assembly;
identifying within a field of view of the AR viewing device at least one composite structure for assembly, the composite structure associated with a dataset comprising at least one assembly sequence (410) of one or more assembly steps;
loading the associated dataset for display via the AR viewing device;
for each assembly step:
displaying, via the AR viewing device, at least one AR object corresponding to the assembly step, the AR object indicative of one or more of a placement and an orientation;
displaying, via the AR viewing device, at least one operator alert associated with the assembly step;
accepting from the at least one operator, via the AR viewing device, operator input associated with a completion of the assembly step;
and
generating, via the AR viewing device, at least one verification of the completed assembly step;
and
generating, based on the one or more generated verifications, at least one record corresponding to a completion of the at least one assembly sequence.

2. The method of claim 1, wherein:
identifying within a field of view of the AR viewing device at least one first composite structure for assembly includes:
identifying at least one composite structure comprising one or more layers to be assembled over at least one mold;
and
displaying, via the AR viewing device, at least one AR object corresponding to the assembly step includes:
displaying at least one AR object indicative of one or more of a layer placement and a layer orientation.

3. The method of claim 2, wherein each layer comprises one or more plies, and displaying, via the AR viewing device, at least one AR object corresponding to the assembly step includes:
displaying at least one AR object indicative of one or more of a ply placement and a ply orientation.

4. The method of claim 2 or 3, wherein displaying, via the AR viewing device, at least one AR object corresponding to the assembly step includes:
displaying, via the AR viewing device, at least one assembly location associated with the assembly step, the assembly location selected from a group including a splice location and a dart location.

5. The method of claim 2, 3 or 4 wherein displaying, via the AR viewing device, at least one AR object corresponding to the assembly step includes:
displaying, via the AR viewing device, at least one dress and drape method associated with the assembly step.

6. The method of any of claims 2 to 5, wherein displaying, via the AR viewing device, at least one AR object corresponding to the assembly step includes:
displaying additional information associated with the composite structure, the additional information selected from a group including a bill of materials, a video clip, and a technical illustration.

7. The method of claim 1, wherein:
identifying within a field of view of the AR viewing device at least one composite structure for assembly includes:
identifying at least one bonded assembly comprising one or more sets of fastening components to be attached to a backing layer;
and
displaying, via the AR viewing device, at least one AR object corresponding to the assembly step includes:
displaying at least one AR object indicative of one or more of a fastening component placement and a fastening component orientation.

8. The method of claim 1, wherein identifying within a field of view of the AR viewing device at least one composite structure for assembly includes:
identifying the at least one composite structure by scanning an image target via the AR viewing device, the image target selected from a group including:
a mold associated with the composite structure;
a backing layer associated with the composite structure;
a work order associated with the composite structure;
a component of the composite structure;
and
encoded information attached to at least one of the mold, the backing layer, and the component.

9. The method of any preceding claim, wherein displaying, via the AR viewing device, at least one operator alert includes:
displaying, via the AR viewing device, one or more operator instructions.

10. The method of any preceding claim, wherein displaying, via the AR viewing device, at least one operator alert includes:
displaying, via the AR viewing device, at least one operator alert associated with a curing oven communicatively coupled to the AR viewing device.

11. The method of any preceding claim, wherein displaying, via the AR viewing device, at least one operator alert includes:
displaying, via the AR viewing device, at least one operator alert associated with a ply cutter communicatively coupled to the AR viewing device.

12. The method of any preceding claim, wherein accepting from the at least one operator, via the AR viewing device, operator input associated with a completion of the assembly step includes:
accepting one or more spoken instructions from the operator;
and
determining one or more assembly steps to be executed based on the one or more spoken instructions.

13. The method of any preceding claim, wherein accepting from the at least one operator, via the AR viewing device, operator input associated with a completion of the assembly step includes:
displaying at least one interactive menu within the field of view of the AR viewing device;
and
accepting the operator input via the interactive menu.

14. The method of any preceding claim, wherein accepting from the at least one operator, via the AR viewing device, operator input associated with a completion of the assembly step includes:
initiating at least one subsequent assembly step of the assembly sequence.
